Europäisches Patentamt
(19) European Patent Office
Office européen des brevets

(11) Veröffentlichungsnummer: **0 011 093 B1**

(12) **EUROPÄISCHE PATENTSCHRIFT**

(45) Veröffentlichungstag der Patentschrift: **07.10.81**

(51) Int. Cl.[3]: **H 03 K 7/08,** G 01 R 19/00

(21) Anmeldenummer: **79103029.9**

(22) Anmeldetag: **20.08.79**

(54) **Impulsdauer-Pausendauer-Modulator.**

(30) Priorität: **13.11.78 CH 11635/78**

(43) Veröffentlichungstag der Anmeldung: **28.05.80 Patentblatt 80/11**

(45) Bekanntmachung des Hinweises auf die Patenterteilung: **07.10.81 Patentblatt 81/40**

(84) Benannte Vertragsstaaten: **DE FR GB IT NL SE**

(56) Entgegenhaltungen:
**US-A-3 074 057**
**US-A-3 441 877**

**INSTRUMENTS AND EXPERIMENTAL TECHNIQUES, Band 19, Nr. 2, Teil 1, März-April 1976, Seiten 400–403 New York, USA**
**OVCHINNIKOV: «An integrating quasisweeping voltage-to-time-interval converter»**

(73) Patentinhaber: **LGZ LANDIS & GYR ZUG AG, Konzern-Patentabteilung, CH-6301 Zug (CH)**

(72) Erfinder: **de Vries, Jacob, Feldbergstrasse 2, CH-6311 Allenwinden (CH)**

(74) Vertreter: **Müller, Hans-Jürgen, Dipl.-Ing. et al, Patentanwälte Dipl.Ing. Hans-Jürgen Müller Dr.rer.nat. Thomas Berendt Lucile-Grahn-Strasse 38, Postfach 80 13 69 D-8000 München 80 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 011 093 B1

# Impulsdauer-Pausendauer-Modulator

Die Erfindung bezieht sich auf einen Impulsdauer-Pausen-Modulator, der im Oberbegriff des Anspruchs 1 genannten Art.

Die Fig. 1 zeigt einen solchen, z. B. aus US-A 3 441 877 bekannten Impulsdauer-Pausendauer-Modulator, auch Mark-Space-Modulator genannt. Eine Messspannung $U_m$ einer nicht dargestellten Messspannungsquelle erzeugt in einem Widerstand $R_1$ einen proportionalen Messstrom $I_m$. Dieser Messstrom fliesst in einen Miller-Integrator M, der aus einem Verstärker V und einem zwischen dessen Eingang und Ausgang geschalteten Kondensator C besteht. An den Ausgang des Verstärkers V ist ein Schmitt-Trigger ST angeschlossen, welcher einen Schalter S einer Referenzspannungsquelle Q steuert. In der einen Stellung des Schalters S ist der Eingang des Verstärkers V über einen Widerstand R mit einer positiven Referenzspannung $+U_r$ und in der anderen Stellung mit einer negativen Referenzspannung $-U_r$ verbunden. Dementsprechend fliesst dauernd ein Referenzstrom $I_r$, der sich dem Messstrom $I_m$ überlagert und je nach der Stellung des Schalters S positiv oder negativ ist, zum Eingang E des Miller-Integrators M.

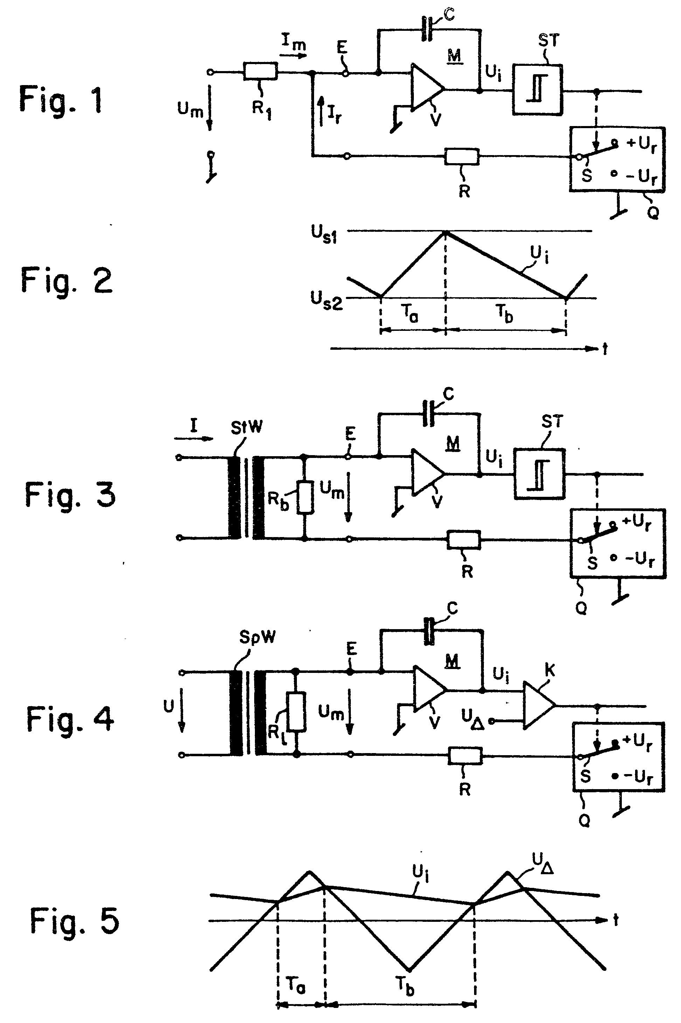

Am Ausgang des Miller-Integrators M entsteht eine Dreieckspannung $U_i$, die gemäss der Fig. 2 jeweils bis zum oberen Schwellenwert $U_{s1}$ des Schmitt-Triggers ST ansteigt, wonach der Schmitt-Triggers ST umkippt, der Schalter S umschaltet, der Referenzstrom $I_r$ seine Polarität umkehrt und die Dreieckspannung $U_i$ bis zum unteren Schwellenwert $U_{s2}$ des Schmitt-Triggers ST abfällt. Am Ausgang des Schmitt-Triggers ST entsteht eine Rechteckspannung mit der Impulsdauer $T_a$ und der Pausendauer $T_b$.

Es gilt

$$\frac{T_a - T_b}{T_a + T_b} = -\frac{I_m}{I_r} = -\frac{U_m}{U_r} \cdot \frac{R}{R_1}$$

Das Verhältnis $\frac{R}{R_1}$ stellt also eine Proportionalitätskonstante dar, was bedingt, dass die Widerstände R und $R_1$ Präzisionswiderstände sein müssen.

Der im Anspruch 1 angegebenen Erfindung liegt die Aufgabe zugrunde, einen Impulsdauer-Pausendauer-Modulator der eingangs genannten Art zu schaffen, bei dem das Verhältnis $\frac{T_a - T_b}{T_a - T_b}$ vom Widerstand R unabhängig ist.

Die zur Lösung dieser Aufgabe bei einem Modulator der eingangs genannten Art getroffenen Massnahmen ergeben sich aus dem Kennzeichen des Anspruchs 1.

Nachfolgend werden Ausführungsbeispiele der Erfindung anhand der Zeichnung näher erläutert. Es zeigen:

Fig. 1 ein Schaltbild des bekannten Impulsdauer-Pausendauer-Modulators,

Fig. 2 ein Spannungs-Zeit-Diagramm,

Fig. 3 und 4 je ein Schaltbild eines erfindungsgemässen Impulsdauer-Pausendauer-Modulators und

Fig. 5 ein weiteres Spannungs-Zeit-Diagramm.

In der Fig. 3 weisen gleiche Bezugszeichen wie in der Fig. 1 auf gleiche Teile hin. Der Impulsdauer-Pausendauer-Modulator nach der Fig. 3 besteht ebenfalls aus einem Miller-Integrator M, einem Schmitt-Trigger ST und einer die Referenzspannung $+U_r$ bzw. $-U_r$ liefernden Referenzspannungsquelle Q. Diese Teile sind in gleicher Weise miteinander verbunden wie in der Fig. 1 und arbeiten auch auf gleiche Weise. Ein Widerstand R ist ebenfalls vorhanden; dieser ist jedoch nicht unmittelbar, sonder in Reihe mit einem Bürdenwiderstand $R_b$ eines Stromwandlers StW zwischen den Eingang E des Miller-Integrators M und die Referenzspannungsquelle Q geschaltet. Der Stromwandler StW wird primärseitig von einem zu messenden Strom I durchflossen und am Bürdenwiderstand $R_b$ fällt eine Messspannung $U_m$ ab. Der als Messspannungsquelle wirkende Bürdenwiderstand $R_b$, die Referenzspannungsquelle Q und der Widerstand R bilden also eine Reihenschaltung, die dauernd zwischen den Eingang E des Miller-Integrators M und Bezugspotential geschaltet ist. Durch diese Reihenschaltung fliesst ein Strom zum Miller-Integrator M, der aus einer zur Messspannung $U_m$ proportionalen Komponente und aus einer zur Referenzspannung $+U_r$ bzw. $-U_r$ proportionalen Komponente besteht.

Es gilt

$$T_a = \frac{U_h \cdot C \quad (R + R_b)}{U_r + U_m}$$

$$T_b = \frac{U_h \cdot C \quad (R + R_b)}{U_r - U_m}$$

und daraus

$$\frac{T_a - T_b}{T_a + T_b} = -\frac{U_m}{U_r}$$

wobei $U_h = U_{s1} - U_{s2}$ bedeutet. Das Verhältnis der Differenz zur Summe von Impulsdauer $T_a$ und Pausendauer $T_b$ ist also im wesentlichen nur von der Messspannung $U_m$ und der Referenzspannung $U_r$ abhängig. Der Widerstand R geht in das Messresultat nicht ein.

Anstelle des Stromwandlers StW mit dem Bürdenwiderstand $R_b$ kann, wie Fig. 4 zeigt, ein Spannungswandler SpW mit einem an dessen Sekundärwicklung angeschlossenen Lastwiderstand $R_L$ dienen, der die zu einer Spannung U proportionale Messspannung $U_m$ liefert und mit dem Widerstand R sowie mit der Referenzspannungsquelle Q in Reihe geschaltet ist.

Zur Überwachung der Spannung $U_i$ des Miller-Integrators M ist in der Anordnung nach der Fig. 4 ein Komparator K vorgesehen, der die Spannung $U_i$ mit einer Dreieckspannung $U_\Delta$ vergleicht und, wie aus der Fig. 5 hervorgeht, die Polarität der Referenzspannung $U_r$ jeweils dann um-

schaltet, wenn die Spannung $U_i$ den Momentanwert der Dreieckspannung $U_\Delta$ überschreitet oder unterschreitet. Es gilt wiederum

$$\frac{T_a - T_b}{T_a + T_b} = \frac{U_m}{U_r}$$

wobei $T_a + T_b$ der Periodendauer der Dreieckspannung $U_\Delta$ entspricht und von der Messspannung $U_m$ unabhängig ist.

## Patentansprüche

1. Impulsdauer-Pausendauer-Modulator zur Erzeugung einer Rechteckspannung, bei der das Verhältnis der Differenz zur Summe von Impulsdauer ($T_a$) und Pausendauer ($T_b$) einer von einer Messspannungsquelle ($R_b$; $R_L$) gelieferten Messspannung ($u_m$) proportional ist, mit einem Integrator (M), einem die Spannung ($U_i$) des Integrators überwachenden Komparator (ST; K), einer Referenzspannungsquelle (Q), deren Polarität vom Komparator gesteuert wird, und einem Widerstand (R), über den die Referenzspannungsquelle an den Eingang (E) des Integrators angeschlossen ist, wobei der Integrator dauernd einen Strom integriert, der aus einer zur Messspannung proportionalen Komponente ($I_m$) und aus einer zur Referenzspannung der Referenzspannungsquelle proportionalen Komponente ($I_r$) besteht, dadurch gekennzeichnet, dass die Messspannungsquelle ($R_b$; $R_L$), die Referenzspannungsquelle (Q) und der Widerstand (R) eine Reihenschaltung bilden, die dauernd zwischen den Eingang (E) des Integrators (M) und Bezugspotential geschaltet ist.

2. Impulsdauer-Pausendauer-Modulator nach Anspruch 1, dadurch gekennzeichnet, dass die Messspannungsquelle aus dem Bürdenwiderstand ($R_b$) eines Stromwandlers (StW) besteht.

3. Impulsdauer-Pausendauer-Modulator nach Anspruch 1, dadurch gekennzeichnet, dass die Messspannungsquelle aus dem Lastwiderstand ($R_L$) eines Spannungswandlers (SpW) besteht.

4. Impulsdauer-Pausendauer-Modulator nach einem der Ansprüche 1 bis 3, dadurch gekennzeichnet, dass der Komparator ein Schmitt-Trigger (ST) ist.

5. Impulsdauer-Pausendauer-Modulator nach einem der Ansprüche 1 bis 3, dadurch gekennzeichnet, dass der Komparator (K) die Spannung ($U_i$) des Integrators (M) mit einer Dreieckspannung ($U_\Delta$) vergleicht.

6. Impulsdauer-Pausendauer-Modulator nach einem der Ansprüche 1 bis 5, dadurch gekennzeichnet, dass der Integrator (M) aus einem Verstärker (V) und einem zwischen dessen Eingang und Ausgang geschalteten Kondensator (C) besteht.

## Claims

1. A mark-space-modulator for producing a rectangular or square wave voltage wherein the ratio of the difference to the sum of the mark duration ($T_a$) and the space duration ($T_b$) is proportional to a measurement voltage ($U_m$) supplied by a measurement voltage source ($R_b$; $R_L$), comprising an integrator (M), a comparator (ST; K) for monitoring the voltage ($U_i$) of the integrator, a reference voltage source (Q), the polarity of which is controlled by the comparator, and a resistor (R) by way of which the reference voltage source is connected to the input (E) of the integrator, wherein the integrator continuously integrates a current which comprises a component ($I_m$) proportional to the measurement voltage, and a component ($I_r$) proportional to the reference voltage of the reference voltage source, characterised in that the measurement voltage source ($R_b$; $R_L$), the reference voltage source (Q) and the resistor (R) from a series circuit which is continuously connected between the input (E) of the integrator (M) and reference potential.

2. A mark-space-modulator according to claim 1 characterised in that the measurement voltage source comprises a load resistor ($R_b$) of a current transformer (StW).

3. A mark-space-modulator according to claim 1 characterised in that the measurement voltage source comprises the load resistor (L) of a transformer (SpW).

4. A mark-space-modulator according to one of claims 1 to 3 characetrised in that the comparator is a Schmitt trigger (ST).

5. A mark-space-modulator according to one of claims 1 to 3 characterised in that the comparator (K) compares the voltage ($U_i$) of the integrator (M) to a triangular voltage ($U_\Delta$).

6. A mark-space-modulator according to one of claims 1 to 5 characterised in that the integrator (M) comprises an amplifier (V) and a capacitor (C) connected between the input and output thereof.

## Revendications

1. Modulateur de rapport cyclique d'impulsions destiné à produire une tension rectangulaire dont le rapport entre la différence et la somme de la durée d'impulsion. ($T_a$) et la durée d'intervalle entre impulsions ($T_b$) est proportionel à une tension de mesure ($U_m$) délivrée par une source de tension de mesure ($R_b$; $R_L$), avec un intégrateur (M), un comparateur (ST; K) qui contrôle la tension ($U_i$) de l'intégrateur, une source (Q) de tension de référence dont la polarité est commandée par le comparateur et une résistence (TR) par laquelle la source de tension de référence est connectée à une entrée (E) de l'integrateur, de manière que l'intégrateur intègre en permanence un courant constitué par une composante ($I_m$) proportionnelle à la tension de mesure et une composante ($I_r$) proportionnelle à la tension de référence de la source de tension de référence, modulateur caractérisé en ce que la source ($R_b$; $R_L$) de tension de mesure, la source (Q) de tension de référence et la résistance (R) constituent un circuit en série, connecté en permanence entre l'entrée (E) de l'intégrateur (M) et un potentiel de référence.

2. Modulateur selon la revendication 1, caractérisé en ce que la source de tension de mesure est constituée par la résistance de charge ($R_b$) d'un transformateur d'intensité (StW).

3. Modulateur selon la revendication 1, caractérisé en ce que la source de tension de mesure est constituée par l'impédance de charge ($R_L$) d'un transformateur de tension (SpW).

4. Modulateur selon d'une quelconque des revendications 1 à 3, caractérisé en ce que le comparateur consiste en un circuit basculeur de Schmitt (ST).

5. Modulateur selon l'une quelconque des revendications 1 à 3, caractérisé en ce que le comparateur (K) compare la tension ($U_i$) de l'intégrateur (M) avec une tension triangulaire ($U_\Delta$).

6. Modulateur selon l'une quelconque des revendications 1 à 5, caractérisé en ce que l'intégrateur (M) est constitué par un amplificateur (V) et un condensateur (C) connecté entre l'entrée et la sortie de cet amplificateur.

Fig. 1

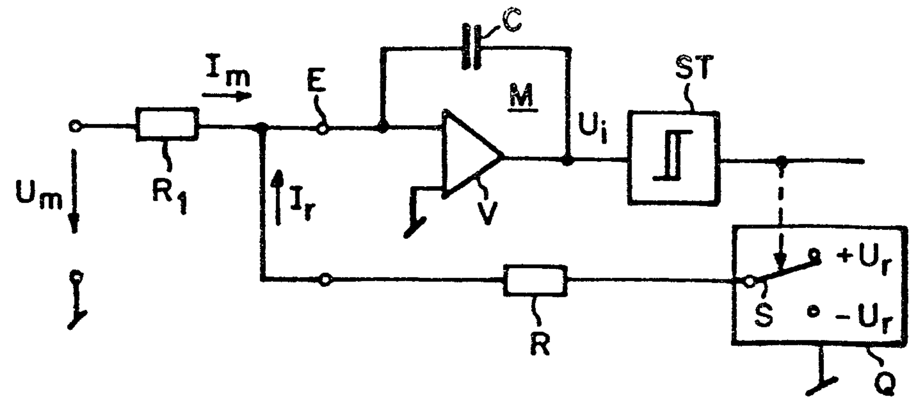


Fig. 2

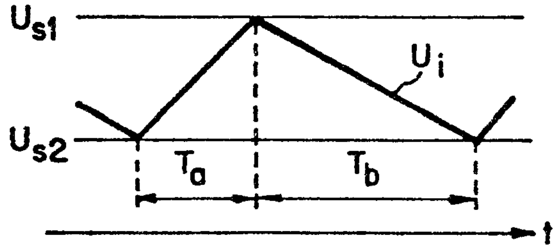


Fig. 3

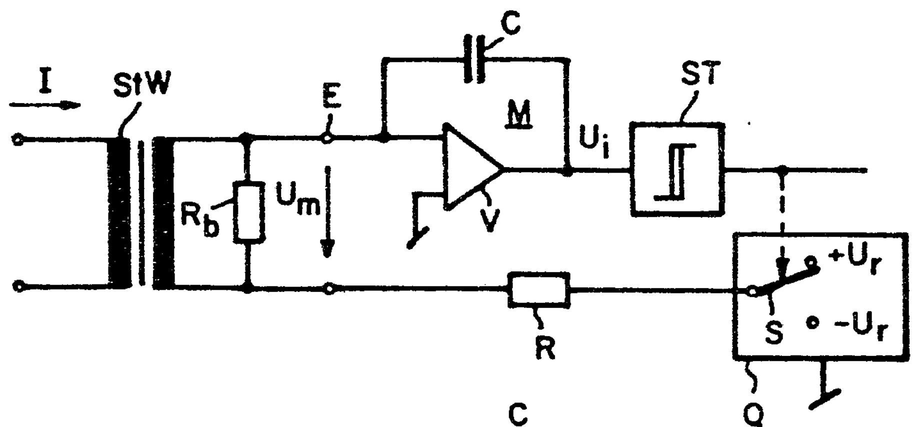


Fig. 4

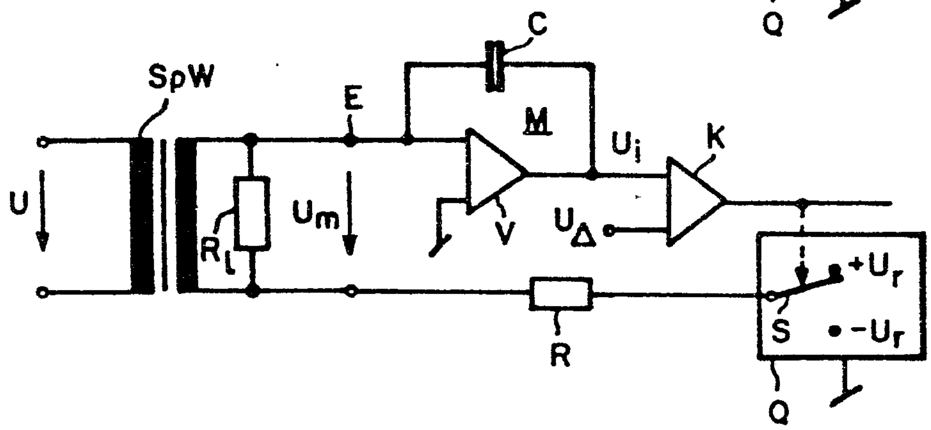


Fig. 5